# EUROPEAN PATENT SPECIFICATION

(11) **EP 4 453 938 B1**
(45) Date of publication and mention of the grant of the patent: **13.05.2026**
(21) Application number: 22835901.4
(22) Date of filing: 20.12.2022
(51) Int. Cl.: G11C 11/44, H10N 10/00, H10N 10/855, H10N 60/00, H10N 60/10

(54) **SUPERCONDUCTING BIPOLAR THERMOELECTRIC MEMORY AND METHOD FOR WRITING A SUPERCONDUCTING BIPOLAR THERMOELECTRIC MEMORY**
SUPRALEITENDER BIPOLARER THERMOELEKTRISCHER SPEICHER UND VERFAHREN ZUM SCHREIBEN EINES SUPRALEITENDEN BIPOLAREN THERMOELEKTRISCHEN SPEICHERS
MÉMOIRE THERMOÉLECTRIQUE BIPOLAIRE SUPRACONDUCTRICE ET PROCÉDÉ D'ÉCRITURE D'UNE MÉMOIRE THERMOÉLECTRIQUE BIPOLAIRE SUPRACONDUCTRICE

(30) Priority: 21.12.2021 IT 202100032042
(43) Date of publication of application: 30.10.2024
(73) Proprietor: Consiglio Nazionale Delle Ricerche, 00185 Roma (IT)
(72) Inventor: GIAZOTTO, Francesco, 56126 Pisa (IT); PAOLUCCI, Federico, 56127 Pisa (IT); BRAGGIO, Alessandro, 16132 Genova (IT); MARCHEGIANI, Giampiero, 56127 Pisa (IT); GERMANESE, Gaia, 50127 Firenze (IT)
(74) Representative: Ernest Gutmann - Yves Plasseraud S.A.S.
(86) International application number: PCT/IB2022/062517
(87) International publication number: WO 2023/119142

(56) References cited:
- G. MARCHEGIANIA. BRAGGIOF. GIAZOTTO: "Nonlinear Thermoelectricity with Electron-Hole Symmetric Systems", PHYSICAL REVIEW LETTERS, vol. 124, 14 March 2020 (2020-03-14), pages 1 - 19, XP002807005
- GAIA GERMANESE ET AL: "Spontaneous symmetry breaking-induced thermospin effect in superconducting tunnel junctions", ARXIV.ORG, CORNELL UNIVERSITY LIBRARY, 201 OLIN LIBRARY CORNELL UNIVERSITY ITHACA, NY 14853, 27 October 2021 (2021-10-27), pages 1, XP091065310
- MARCHEGIANI G ET AL: "Noise effects in the nonlinear thermoelectricity of a Josephson junction", ARXIV.ORG, CORNELL UNIVERSITY LIBRARY, 201 OLIN LIBRARY CORNELL UNIVERSITY ITHACA, NY 14853, 11 September 2020 (2020-09-11), XP081760687

## Description

The present invention relates to a superconducting memory capable of encoding a logic state into an output electrical voltage, thanks to the presence of a finite thermal gradient representing the power supply of the memory itself (bipolar thermoelectric effect), and to a method for writing such superconducting memory.

The recent quantum technologies development has led to increasing interest in the study of thermoelectric phenomena in superconducting and hybrid devices. The main reason lies in the control of thermal phenomena, which are inevitably generated in devices used in computing environments. The innovative methodologies are focused on the management of the heat generated in this kind of devices and the miniaturization of their components; they represent the main challenge in both classical and quantum computation. Moreover, the possibility to control thermoelectric phenomena generated in superconductors becomes also an asset for the development of new high-sensitivity sensors.

One of the main challenges related to these technologies is recycling the heat produced in computing environments.

Known superconducting memories [IEEE Trans. Appl. Supercond. 2, 95-100 (1992); Phys. Procedia 36, 35-41 (2012); IEEE Trans. Appl. Supercond. 23, 1701208-1701208 (2013); Nat. Commun. 5, 3888 (2014); Nat. Commun 6, 8628 (2015); New J. Phys. 19, 063015 (2017); Supercond. Sci. Technol. 32, 015001 (2018); Appl. Phys. Lett. 118, 112603 (2021)] do not contribute to the recycling of the heat produced in computing environments, and they have limitations in response times since they are driven by magnetic field pulses.

There is therefore the need to have a superconducting memory capable of employing the heat dissipated in electrical components exploited in quantum and classical computation, with high response speed, and stable and durable performances, thus overcoming the problems of the prior art.

These and other objects are fully achieved by virtue of a superconducting bipolar thermoelectric memory having the characteristics defined in independent claim 1, and by a method for writing a superconducting memory having the characteristics defined in claim 4.

Preferred embodiments of the invention are specified in the dependent claims 2 and 3.

Only embodiments or examples comprising all the features of independent device claim 1 or of independent method claim 4 fall under the scope of protection of the present invention.

Further characteristics and advantages of the present invention will become apparent from the following description, provided merely by way of non-limiting example, with reference to the attached drawings, in which:
- Figure 1 shows a schematic view of the electrical circuit of a superconducting bipolar thermoelectric memory according to the present invention;
- Figure 2 shows a graph of the output voltage vs. the injected current in the superconducting memory;
- Figure 3 shows multiple hysteretic curves of figure 2 obtained by applying raising thermal gradients;
- Figures 4a - 4c show a top view of junctions forming the thermoelectric element of the superconducting memory;
- Figure 5 shows a sectional view of a Superconductor-Insulator-Superconductor-Ferromagnetic insulator junction;
- Figure 6 shows a sectional view of a Superconductor-Insulator-Semiconductor junction according to the present invention;
- Figure 7 shows a current-voltage characteristic of the thermoelectric element; and
- Figure 8 shows a block diagram of the step of a method for writing a superconducting memory according to the present invention.

The present invention is a superconducting memory based on the bipolar thermoelectric effect. The superconducting memory encodes two (or more) logic states into an electrical output voltage in the presence of a fixed thermal gradient, which can be determined by a direct power supply or from another source of heat (heat harvesting).

The memory is volatile since, in the absence of a temperature gradient (power supply), it cannot store the output state.

The superconducting bipolar thermoelectric memory of the present invention allows reconverting the heat dissipated in logic elements of a circuit into on-chip reusable electrical DC power. In particular, the superconducting memory exploits a bipolar thermoelectric effect generated in a superconducting tunnel junction in the presence of a thermal gradient (nonlinear regime) across the junction [Phys. Rev. Lett. 124, 106801 (2020); Phys. Rev. B 101, 214509 (2020); Phys. Rev. B 104, 184502 (2021)], assuming a suppressed Josephson coupling, which would be detrimental for the operation of the memory itself.

An appropriate material and design selection, used for the realization of the superconducting memory, potentially permits extending its operating range to not only cryogenic temperatures. In this way, the superconducting memory becomes easier to apply.

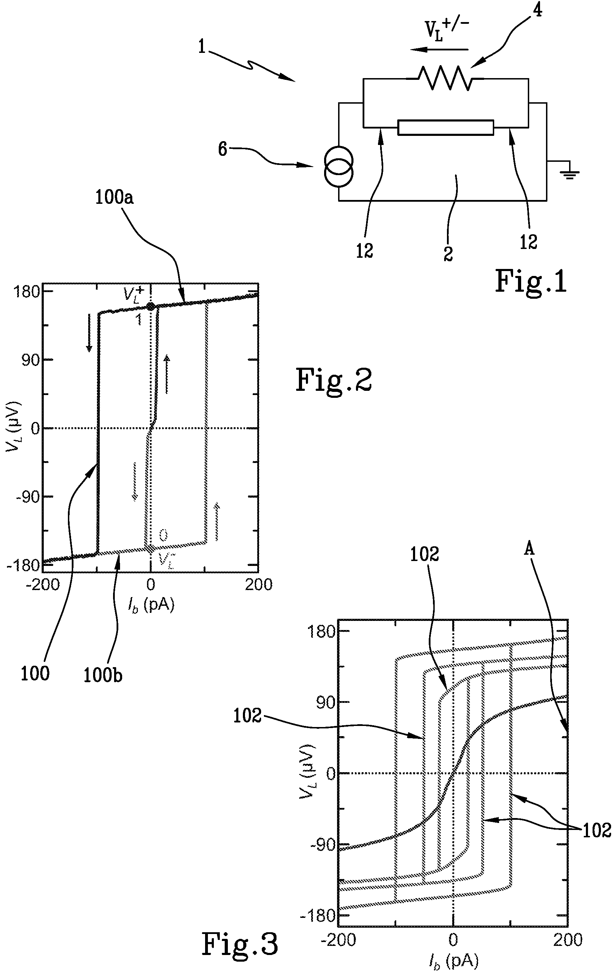

Figure 1 shows a schematic view of the electric circuit of a superconducting bipolar thermoelectric memory 1 according to the present invention.

The superconducting memory 1 is based on a circuit comprising a connection in parallel between a bipolar thermoelectric element 2 and a predetermined resistive load 4.

The whole parallel branch of the circuit is connected to a current generator 6, which represents the writing/erasing control element of the circuit, arranged to send an injected (controlled) current I_{b} in the parallel of the thermoelectric element 2 and the resistive load 4.

The injected current I_{b} divides into two branches, the one of the resistive load 4 and the one of the thermoelectric element 2, depending on the resistance it encounters. When the thermoelectric element 2 behaves as a dissipative element (it does not generate thermoelectric current), the current I_{b} passes mainly into the branch of the thermoelectric element 2 because its resistance is less than the resistance of the resistive load 4. When the thermoelectric element 2 behaves as an active element (it generates thermoelectric current I_{TE} against the voltage), the injected current I_{b} adds with I_{TE} and both flows in the resistive load 4. When the injected current I_{b} is reset to zero (I_{b}=0), only the thermoelectric current I_{TE} generated by the thermoelectric element 2 circulates in the resistive load 4.

The thermoelectric element 2 is arranged to be heated with a predetermined fixed thermal gradient, to encode logic states as output voltages V_{L}⁺, V_{L}⁻ across the resistive load 4, which depend on the sign of the injected current I_{b} at the writing stage. Once the parallel circuit of the thermoelectric element 2 and the resistive lead 4 reaches one of the two metastable states at the output voltages V_{L}⁺, V_{L}⁻ , even if the injected current I_{b} is switched off, the circuit remains in the memorized state at least until the thermal gradient is applied.

Unlike traditional superconducting memories driven by a magnetic field, the writing/erasing mechanism of the superconducting memory 1 of the present invention is performed through a direct injection of current into the superconducting memory 1. In particular, by injecting a positive or negative current I_{b} (writing/erasing) directly into the parallel branch of the circuit, output states can be encoded as corresponding output voltages V_{L}⁺ or V_{L}⁻ across the resistive load 4, thus showing two discrete values (1/0 state).

A thermal gradient (power supply) is applied to the thermoelectric element 2, and it determines the two output voltage levels (states) thanks to the bipolar thermoelectric effect, which correspond to two different logic states.

The thermal power supply can be provided to the superconducting memory 1 either by an external source or by exploiting the heat dissipated by other electrical elements in a superconducting logic circuit per se known (not shown in the figures), associated with the superconducting memory 1, during computing operations. Therefore, since this volatile memory works in synergy with a related logic circuit (quantum or classical), the superconducting memory 1 of the present invention, in principle, does not need to be supplied by an external source, but it could exploit the heat losses of other devices, thus reducing the number of the required control lines (which represent a severe constrain at certain cryogenic temperatures).

The maximum distance between the two output voltage states occurs for the minimum but finite thermal gradient, thus requiring a lower possible power supply, as detailed here below.

Figure 2 shows a graph of the output voltage V_{L} *vs.* the injected current I_{b} of the superconducting memory element 1.

This voltage-current characteristic or curve 100 presents a hysteretic behavior with non-zero output voltages (V_{L}^{+/}N_{L}⁻) in a respective top 100a or bottom 100b part of the curve 100, even in the absence of injected current I_{b} (I_{b} equal to 0). The superconducting memory 1 is, therefore, able to store one of the two logical states (1 or 0), once the writing/erasing mechanism is activated.

The superconducting memory 1 is arranged to reach corresponding states based on the sign of the injected current I_{b}, which determines the sign of the generated voltage V_{L}⁺/N_{L}⁻, as detailed hereinbelow.

Figure 3 shows different curves 102 corresponding to the hysteretic curve 100 of Figure 2 for the superconducting memory 1 obtained by applying different thermal gradients, which increase in the direction of the arrow A.

From Figure 3, it is clear that the maximum distance between the two states (i.e., the maximum distance between the two generated output voltages V_{L}⁺, V_{L}⁻) occurs for low thermal powers. Therefore, the distance between the two possible states decreases by increasing the input power (thermal gradient). The two output voltages remain almost constant, instead, changing the resistive load 4, at least until the resistive load 4 reaches a minimum resistance that can be supported by the thermoelectric element 2.

The superconducting memory 1 is based on the thermoelectric element 2, which can be realized by exploiting different kinds of tunnel junctions per se known, based on superconductors and materials with an appropriate energy gap. Conveniently, the chosen materials present a predetermined level of particle-hole symmetry. Indeed, the bipolar thermoelectric effect, which develops in these junctions, is substantially determined by the spontaneous breaking of this symmetry in the nonlinear regime (finite thermal gradients).

The tunnel junctions are preferably realized with different superconducting materials (Superconductor₁-Insulator-Superconductor₂) with BCS (Bardeen-Cooper-Schrieffer) superconductors, multiband or nonconventional and/or even high-temperature superconductors, hybrid junctions with ferromagnet-insulator-superconductor (Superconductor-Insulator-Superconductor-Ferromagnetic), superconductor-semiconductor (Superconductor-insulator-Semiconductor), Superconductor-Insulator-Carbon based junctions with nanotubes, nanoribbons or bilayers of graphene. Each combination of materials results in peculiar operating ranges (temperatures, voltage ranges, and thermodynamic efficiencies) and operating characteristics (the number of logic levels), which can be exploited to own advantage.

In particular, three different types of design for the junctions that can be used are here below disclosed.

The first type of junctions is that based on different superconducting materials (Superconductor₁-Insulator-Superconductor₂) obtained by embedding them (or not) in a superconducting quantum interference device (SQUID).

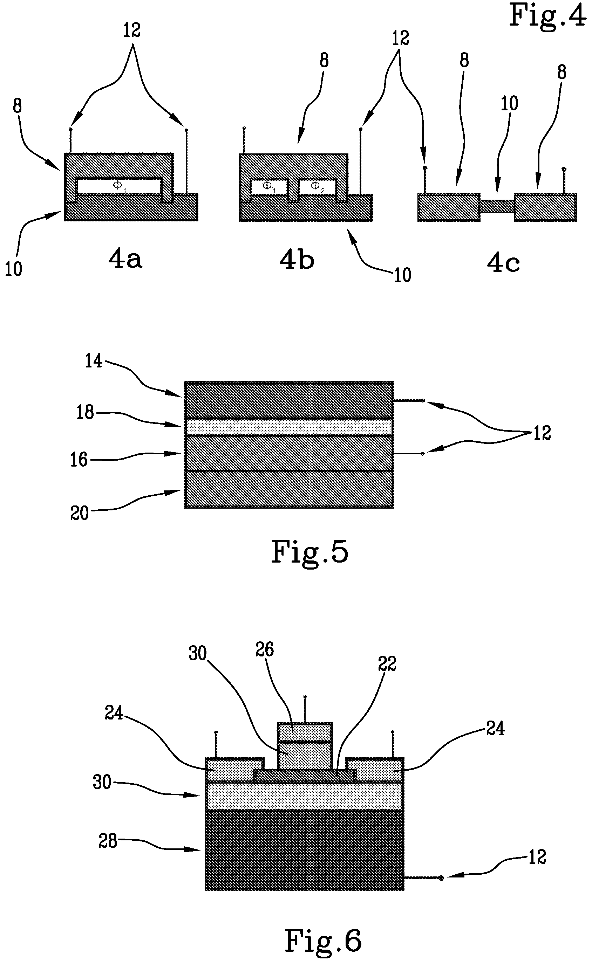

Figures 4a - 4c show a top view of such junctions where the references 8 and 10 indicate a first and a second element made up of respectively a first superconducting material Superconductor₁ and a second superconducting material Superconductor₂. The two superconducting materials should be selected/designed properly to keep the ratio between the two energy gaps different from 1 and in the range 0.3-0.7 to get the best bipolar thermoelectrical performances.

In Figure 4a the first element 8 is a layer having a C-section and it is coupled to the second element 10 which is a layer having a linear section.

In Figure 4b the first element 8 is a layer having an E-section and it is coupled to the second element 10 which is a layer having a linear section.

In Figure 4c the first element 8 comprises two portions having linear sections connected to the second element 10 which is a layer having a linear section.

Reference 12 indicates the contacts of the thermoelectric element 2 arranged to connect the thermal element 12 to the rest of the circuit of the superconducting memory 1 (see also Figure 1). In all three designs, the thermal gradient has to be established between elements 8 and 10. In such junctions, the presence of the Josephson coupling is detrimental to the thermoelectric effect (electrically shortening the junction). For this reason, the critical current is reduced by using a magnetic flux through a SQUID with a single (Fig. 4a) or double ring (Fig. 4b) or by adopting a simplified design by using very opaque junctions (high resistance in the normal state) (Fig. 4c). Figure 4a shows a SQUID with a single ring, where Φ1 is the flux through the loop, Figure 4b shows a SQUID with a double ring, where Φ1 and Φ2 are the magnetic fluxes through the loops and Figure 4c shows strongly opaque tunnel junction. Another option to reduce the Josephson coupling is to use the so-called "*Fraunhofer effect*" in extended junctions with an in-plane fixed magnetic field, which creates destructive interference of the Josephson component.

The second type of junctions is the Ferromagnetic insulator-Superconductor hybrid junction (S-I-S-FM), which exploit the interaction between the ferromagnetic insulator and the adjacent superconductor [Phys. Rev. B 104, 184502 (2021)]. In this class of devices, the writing mechanism could also be done by charge or spin currents. In this case, the superconducting memory 1 can interact with devices using spin logic elements, inherent to spintronics.

Figure 5 shows a sectional view of a Superconductor-Insulator-Superconductor-Ferromagnetic insulator junction (S-I-S-FM), where a first and a second superconductor layers 14 and 16 are separated by an insulator layer 18. In this design the two layers 14, 16 can have the same energy gap. The second superconductor layer 16 interacts with an adjacent ferromagnetic insulator layer 20, while the first superconductor layer 14 is the hot electrode. In this design the Josephson coupling, if present, can be suppressed using the same methods discussed in the previous designs.

The third type of junctions is the Superconductor-Insulator-Semiconductor junction (S-I-Semi), where the energy gap of the Semiconductor (the conductivity) can be even manipulated by an electric field applied to the structure (top/bottom gate).

Figure 6 shows a sectional view of a Superconductor-Insulator-Semiconductor junction according to the present invention, where a semiconductor layer 22 is put in contact with a superconductor layer 24, which acts as the cold electrode of the device. The semiconductor layer 22 has an energy gap (E_{g}) comparable with the superconducting gap (Δ*s*) of the superconductor layer 24.

In the present description, comparable indicates that the ratio 2Δs/Eg is in the range between 0.3-0.7 to guarantee the best bipolar thermoelectrical performance.

The presence of a metallic top gate 26 and a bottom gate 28 controls the semiconductor layer doping. If the semiconductor is implemented in the form of a graphene bilayer, the energy gap of the semiconductor bilayer is tunable by varying the electric voltage difference between the top gate 26 and the bottom gate 28. An oxide layer 30 is placed between the semiconductor layer 22 and the top and bottom gates 26, 28. An advantage is the possibility to exploit the semiconductor layer 22 as the hot electrode. A further option is to couple a superconductor with other carbon-based nanostructures such as nanotubes and/or nanoribbons, where the nanostructure design determines the gap of the material. In such a case, the carbon-based nanostructures or the graphene bilayer is used as semiconductor layer 22. It is possible to use its intrinsic superconducting properties (for magic-angle graphene bilayer), and it is possible to control by field-effect not only its conductivity (the number of available states used in charge transport) but also the gap and its chemical potential (the material doping). Finally, due to the low dimensionality of the material, it is less demanding to keep a finite thermal gradient in the material without affecting too much the nearby elements.

Josephson coupling typically does not affect the behavior of this kind of structures of Figure 6. In addition, the operating temperature of the hot lead is not limited by a certain critical temperature, which, instead, restricts the possible implementations of the junctions of Figure 4 and Figure 5.

As predicted by recent theoretical studies and experimentally demonstrated, in a Superconductor₁-Insulator-Superconductor₂ junction, by heating the superconductor with a higher energy gap, a thermoelectric current is spontaneously generated by the thermoelectric element 2 in opposition to applied voltages, when the voltage value is smaller than a predetermined Seebeck voltage Vs (|V|<|V_{S}|).

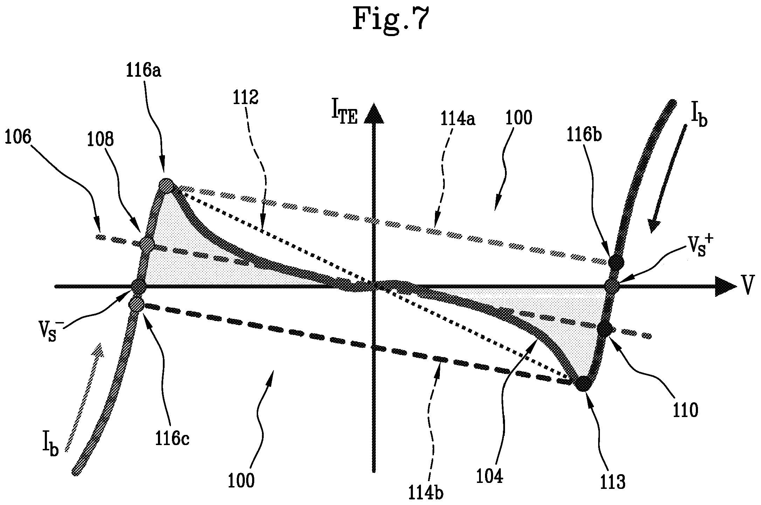

Figure 7 shows a current-voltage (I_{TE}V) characteristic of the thermoelectric element 2 (when the thermoelectric element 2 is connected to a voltage generator) where the references V_{S}^{+/-} indicate the *Seebeck* voltages.

Figure 7 basically corresponds to Figure 2 wherein the voltage generator replaces the current generator, and there is no resistive load 4 connected in parallel (different set-up).

A thermoelectric current I_{TE} (curve 104) is spontaneously generated by the thermoelectric element 2 when I_{TE}V<0, being the element in the thermoactive regime.

In the set-up used for obtaining the thermoelectric curve 104 (a voltage generator applied to the thermoelectric element 2), in absence of any current control I_{b} (I_{b} equal to 0), if the resistive load 4 is put in parallel to the thermoelectric element 2, the generated thermoelectric current I_{TE} flows in the resistive load 4 (the situation represented by a load line 106). The crossings between the load line 106 and the I_{TE} curve 104 determine an upper point 108 (V_{L}⁻, I_{TE}(V_{L}⁻)) and a down point 110 (V_{L}⁺, I_{TE}(V_{L}⁺)), which correspond to the two logic metastable states of the superconducting thermoelectric memory 1. The upper point 108 corresponds to the 0 state and the down point 110 corresponds to the 1 state (respectively (V_{L}⁻, I_{b}=0) and (V_{L}⁺, I_{b}=0)). Notably, if the load resistance is smaller than a minimum value represented by the inverse of the absolute value of the slope of a dashed resistive nominal line 112, the thermoelectric element 2 is not able to provide enough power to sustain a current flowing in the resistive load 4, thus making impossible to establish the metastable states. That value constitutes the minimum possible load resistance of the resistive load 4 to get the bipolar thermoelectric memory cell.

The injected current I_{b} is used to switch the parallel of the thermoelectric element 2 and resistive load 4, which constitutes the memory cell.

The resistive load 4 is realized through a metallic element, or a semiconducting element, whose resistance can be controlled by field-effect, or a metallic junction (Metal-Insulator-Metal). Advantageously, it is fabricated directly on the same substrate of the thermoelectric element 2. Its nominal value must be greater than the minimum resistance that can be supported by the junction (dashed line 112 in Figure 7), corresponding to the absolute value of the ratio of the voltage and the current at a peak point 113 of the thermoelectric curve 104.

The whole superconducting memory 1 (the bipolar thermoelectric element 2 and the load resistor 4), is arranged to be set at an appropriate predetermined temperature, to ensure the superconductive state of the thermoelectric element 2. Lower temperatures can promote the memory thermal stability by limiting the noise on the output voltage due to thermal excitations. Appropriate electrical design of the junction capacitance could be also used to reduce the adverse effects of noise. On the other hand, the current generator 6 can be arranged to work at room temperature to facilitate its use without degrading the performance of the bipolar thermoelectric memory 1.

The operation of this memory is based on a predetermined thermal gradient applied across the junction of the thermoelectric element 2. It is necessary to keep the superconductors at a temperature lower than their critical temperature and to heat the material of the junction that has the largest energy gap.

The superconducting memory 1 can operate in two different regimes: a "*saturation*" regime and a "*threshold value*" regime.

In the "*saturation*" regime, continuous injection of the current I_{b} determines the memory state. Once the output voltage V_{L}^{+/-} has been reached, if the injected current I_{b} is put to zero (memory state), the superconducting memory 1 remains locked in the last logic state. This writing process stores one of two logic states by selecting the sign of the injected current.

The *"threshold value"* regime can be obtained only when the residual Josephson component of the junction is large enough to determine a third metastable state also at V=0. In such a case, a small current is exploited to unbalance the junction, which spontaneously moves into one of two possible logic states. Small current pulses, smaller than the values shown in the hysteresis cycle 100, can trigger the voltage state from V=0 to one of the two metastable states. Starting from a zero-bias metastable configuration (V_{L} and I_{b} equal to 0), the superconducting memory 1 jumps into one of the two memory states with small pulses of current (positive/negative). In this configuration, the superconducting memory 1 can also act as a current threshold detector.

In general, in an initial state ((I_{b},V_{L}) = (0,0)), the superconducting memory 1 is "*activated*" by a continuous current to start the memory process, then, the superconducting memory 1 continues to be used in the *"saturation"* regime up to the switching off of the superconducting memory 1 (removal of the thermal gradient). Then, the process starts again in the next use of the superconducting memory 1. Electrically shortening the junction by imposing V=0 to the junction restores the particle-hole symmetry and constitutes a sort of "*reset*" of the memory to the V=0 metastable state (if present).

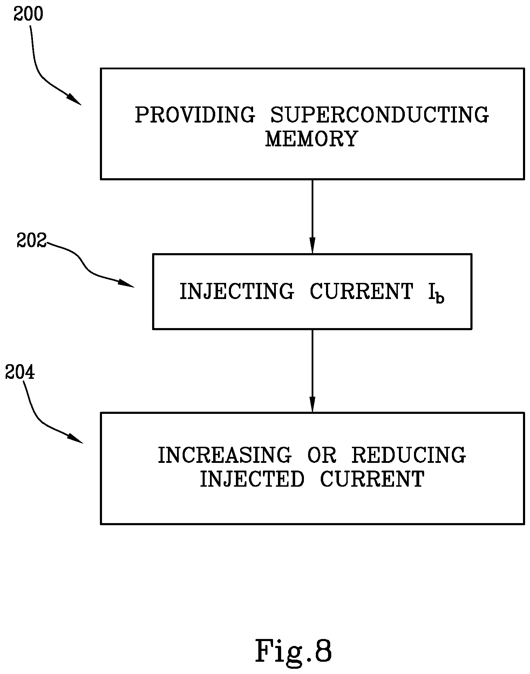

Figure 8 shows a block diagram of the step of a method for writing a superconducting memory 1.

In a first step 200, a superconducting memory 1 as above disclosed is provided and a thermal gradient is applied to it (see "Nonlinear Thermoelectricity with Electron-Hole Symmetric Systems" di G. Marchegiani, A. Braggio and F. Giazotto, Physical Review Letters 124, 106801 (2020)). This creates the conditions to have a bipolar thermoelectric effect in the junction.

In a subsequent step 202, an injected current I_{b} is sent to the thermoelectric element 2 and the resistive load 4, thus causing the generation of an output voltage V_{L} on the resistive load 4 having a positive (V_{L}⁺) or negative (V_{L}⁻) value depending on the sign of the injected current I_{b}.

Injecting a bias current I_{b} in the parallel means, figuratively, to sweep the thermoelectric curve 104 with the load line 106 with a slope equals to (-1/RL) and the value of intercept with the I_{TE} axis equals to I_{b} (in Figure 7, dashed lines 114a, 114b correspond to the load line 106 in two different positions linked two different values of I_{b}). The voltage values of crossing points 116a, 116b, 116c, the upper point 108, the down point 110, and the peak point 113, obtained by crossing the thermoelectric curve 104 and the load lines 106, 114a, 114b, are the voltages V_{L}(I_{b}), which are measured at the output of the superconducting memory 1. These values constitute the hysteresis of the superconducting memory 1. Indeed, connecting the crossing points 116a, 116b, 116c, the upper point 108, the down point 110 and the peak point 113, a hysteretic curve is obtained which corresponds to the hysteresis curve 100 of Figure 2 (with almost a 90° rotation). In particular, for I_{b}=0 the load line 106 crosses the thermoelectric curve 104 in V_{L}⁺ and in V_{L}⁻, which corresponds to the two logic states (1/0) of the superconducting memory 1.

The output voltage V_{L} remains at its acquired positive or negative value on the top 100a or bottom 100b part of the curve 100 of Figure 2.

After the writing mechanism, the memory remains triggered in the metastable state even when I_{b}=0. This is the typical state of the memory, where no current is required from the external generator but only the thermal gradient provides the power necessary to sustain the memory.

By increasing or reducing the injected current I_{b}, it passes, at step 204, on the opposite part of the curve 100 (i.e. the output voltage V_{L} changes its sign), thus changing the state of the superconducting memory 1.

The superconducting memory 1 of the present invention exploits fabrication techniques and superconducting materials already widely tested in the industry (SQUID, RSFQ, etc.), therefore, it has direct application in classical and quantum computation, where the heat dissipated in circuit components can be recovered and reused to thermally supply the device, which generates the usable electrical power.

The superconducting memories used so far are driven in a magnetic field, showing limitations in response times [Phys. Proc. 36, 35-41 (2012)]. By exploiting an injection current, instead, the response time of the memory is determined exclusively by the resistances and capacitances of the superconducting junctions (RC circuits), improving its performance.

In addition, the coupling with a magnetic field in the existing superconducting memories requires devices of high inductance, which can be difficult to miniaturize. Instead, the superconducting memory 1 of the present invention can be strongly miniaturized due to the purely galvanic writing/erasing mechanism.

Moreover, the writing/erasing method of the present invention (current bias) guarantees the operation of the superconducting memory 1 itself, by selecting one of the two logic output states. No external current in the current generator is necessary to keep the memory state, at least until the thermal bias in the junction is preserved (by power supply or harvested heat). The superconducting memory 1 would not work if it were driven by a bias voltage, as a thermoelectric element is normally investigated [Phys. Rev. Lett. 124, 106801 (2020)]. Indeed, if the current generator was substituted by a voltage generator, resetting the voltage to zero would also result in the annulment of the thermoelectric effect and, therefore, completely reset the superconducting memory 1.

Clearly, the principle of the invention remaining the same, the embodiments and the details of production can be varied considerably from what has been described and illustrated purely by way of non-limiting example, without departing from the scope of protection of the present invention as defined by appended claims 1-4.

## Claims

1. Superconducting bipolar thermoelectric memory (1) comprising:
- a bipolar thermoelectric junction (2) and a predetermined resistive load (4) electrically connected in parallel, and
- a current generator (6) configured to inject a current (I_{b}) in the bipolar thermoelectric junction (2) and the predetermined resistive load (4),
wherein
- the bipolar thermoelectric junction (2) is arranged to be heated by a predetermined thermal gradient and to generate corresponding output voltages (V_{L}⁺, V_{L}⁻) on the resistive load (4) depending on the sign of the injected current (I_{b}), these output voltages (V_{L}⁺, V_{L}⁻) corresponding to respective logic states (0, 1) stored by the supercondcuting bipolar thermoelectric memory (1); and
- the bipolar thermoelectric junction including a semiconductor layer (22) put in contact with a superconductor layer (24) which is configured to act as a cold electrode of the superconducting bipolar thermoelectric memory (1), the semiconductor layer (22) having an energy gap Eg comparable with the energy gap 2Δs of the superconductor layer (24) implying that the ratio 2Δs/Eg is in the range between 0.3 - 0.7 and the bipolar thermoelectric junction further including a metallic top gate (26) and a bottom gate (28) configured to control the energy gap of the bipolar thermoelectric junction and an oxide layer (30) placed between the semiconductor layer (22) and the top and bottom gates (26, 28).

2. Superconducting bipolar thermoelectric memory (1) according to claim 1, wherein a maximum distance between the output voltages (V_{L}⁺, V_{L}⁻) decreases by increasing the predetermined thermal gradient.

3. Superconducting bipolar thermoelectric memory (1) according to any of the preceding claims. wherein the bipolar thermoelectric junction (2) and the load resistor (4) are arranged to be placed at a predetermined cryogenic temperature to ensure the superconductive state of the bipolar thermoelectric junction (2), and the current generator (6) is arranged to be placed at room temperature.

4. Method for writing a superconducting bipolar thermoelectric memory comprising the steps of:
- providing (200) a superconducting bipolar thermoelectric memory (1) according to any of the preceding claims and applying a thermal gradient to the superconducting bipolar thermoelectric memory (1);
- injecting (202) a current (I_{b}) to the bipolar thermoelectric junction (2) and the resistive load (4), thus causing the generation of the output voltage (V_{L}) on the resistive load (4) having a positive (V_{L}⁺) or negative (V_{L}⁻) value depending on the sign of the injected current (I_{b}); and
- increasing or reducing the injected current (I_{b}) so that the output voltage (V_{L}) changes (204) its sign, thus changing the state of the superconducting bipolar thermoelectric memory (1).

## Patentansprüche

1. Supraleitender bipolarer thermoelektrischer Speicher (1), umfassend:
- einen bipolaren thermoelektrischen Übergang (2) und eine vorbestimmte resistive Last (4), welche elektrisch parallel geschaltet sind, und
- einen Stromgenerator (6), welcher dazu eingerichtet ist, einen Strom (I_{b}) in den bipolaren thermoelektrischen Übergang (2) und die vorbestimmte resistive Last (4) einzuspeisen,
wobei
- der bipolare thermoelektrische Übergang (2) derart eingerichtet ist, dass er durch einen vorbestimmten thermischen Gradienten erwärmt wird und entsprechende Ausgangsspannungen (V_{L}⁺, V_{L}⁻) an der resistiven Last (4) in Abhängigkeit des Vorzeichens des eingespeisten Stroms (I_{b}) erzeugt, wobei diese Ausgangsspannungen (V_{L}⁺, V_{L}⁻) jeweiligen logischen Zuständen (0, 1) entsprechen, welche durch den supraleitenden bipolaren thermoelektrischen Speicher (1) gespeichert sind; und
- der bipolare thermoelektrische Übergang eine Halbleiterschicht (22) umfasst, welche mit einer Supraleiterschicht (24) in Kontakt gebracht ist, die dazu eingerichtet ist, als eine kalte Elektrode des supraleitenden bipolaren thermoelektrischen Speichers (1) zu wirken, wobei die Halbleiterschicht (22) eine Energielücke Eg aufweist, welche mit der Energielücke 2Δs der Supraleiterschicht (24) vergleichbar ist, was bedeutet, dass das Verhältnis 2Δs/Eg in dem Bereich zwischen 0,3 - 0,7 liegt, und der bipolare thermoelektrische Übergang ferner ein metallisches oberes Gate (26) und ein unteres Gate (28), welche dazu eingerichtet sind, die Energielücke des bipolaren thermoelektrischen Übergangs zu steuern, und eine Oxidschicht (30) umfasst, welche zwischen der Halbleiterschicht (22) und dem oberen und dem unteren Gate (26, 28) platziert ist.

2. Supraleitender bipolarer thermoelektrischer Speicher (1) nach Anspruch 1, wobei ein maximaler Abstand zwischen den Ausgangsspannungen (V_{L}⁺, V_{L}⁻) durch ein Erhöhen des vorbestimmten thermischen Gradienten abnimmt.

3. Supraleitender bipolarer thermoelektrischer Speicher (1) nach einem der vorhergehenden Ansprüche, wobei der bipolare thermoelektrische Übergang (2) und der Lastwiderstand (4) derart eingerichtet sind, dass sie bei einer vorbestimmten kryogenen Temperatur platziert sind, um den supraleitenden Zustand des bipolaren thermoelektrischen Übergangs (2) sicherzustellen, und der Stromgenerator (6) derart eingerichtet ist, dass er bei Raumtemperatur platziert ist.

4. Verfahren zum Beschreiben eines supraleitenden bipolaren thermoelektrischen Speichers, umfassend die folgenden Schritte:
- Bereitstellen (200) eines supraleitenden bipolaren thermoelektrischen Speichers (1) nach einem der vorhergehenden Ansprüche und Anlegen eines thermischen Gradienten an den supraleitenden bipolaren thermoelektrischen Speicher (1);
- Einspeisen (202) eines Stroms (I_{b}) in den bipolaren thermoelektrischen Übergang (2) und die resistive Last (4), wodurch die Erzeugung der Ausgangsspannung (V_{L}) an der resistiven Last (4), welche einen positiven (V_{L}⁺) oder einen negativen (V_{L}⁻) Wert aufweist, in Abhängigkeit des Vorzeichens des eingespeisten Stroms (I_{b}) bewirkt wird; und
- Erhöhen oder Verringern des eingespeisten Stroms (I_{b}), so dass die Ausgangsspannung (V_{L}) ihr Vorzeichen ändert (204), wodurch der Zustand des supraleitenden bipolaren thermoelektrischen Speichers (1) geändert wird.

## Revendications

1. Mémoire thermoélectrique bipolaire supraconductrice (1) comprenant :
- une jonction thermoélectrique bipolaire (2) et une charge résistive prédéterminée (4) connectées électriquement en parallèle, et
- un générateur de courant (6) configuré pour injecter un courant (l₆) dans la jonction thermoélectrique bipolaire (2) et la charge résistive prédéterminée (4),
dans laquelle
- la jonction thermoélectrique bipolaire (2) est agencée pour être chauffée par un gradient thermique prédéterminé et pour générer des tensions de sortie correspondantes (V_{L}⁺, V_{L}⁻) sur la charge résistive (4) en fonction du signe du courant injecté (lₚ), ces tensions de sortie (V_{L}⁺, V_{L}⁻) correspondant à des états logiques respectifs (0, 1) stockés par la mémoire thermoélectrique bipolaire supraconductrice (1) ; et
- la jonction thermoélectrique bipolaire comportant une couche semi-conductrice (22) mise en contact avec une couche supraconductrice (24) qui est configurée pour agir comme une électrode froide de la mémoire thermoélectrique bipolaire supraconductrice (1), la couche semi-conductrice (22) présentant une bande interdite Eg comparable à la bande interdite 2Δs de la couche supraconductrice (24) impliquant que le rapport 2Δs/Eg soit dans la plage comprise entre 0,3 et 0,7 et la jonction thermoélectrique bipolaire comportant en outre une grille métallique supérieure (26) et une grille inférieure (28) configurée pour commander la bande interdite de la jonction thermoélectrique bipolaire et une couche d'oxyde (30) placée entre la couche semi-conductrice (22) et les grilles supérieure et inférieure (26, 28).

2. Mémoire thermoélectrique bipolaire supraconductrice (1) selon la revendication 1, dans laquelle une distance maximale entre les tensions de sortie (V_{L}⁺, V_{L}⁻) diminue avec l'augmentation du gradient thermique prédéterminé.

3. Mémoire thermoélectrique bipolaire supraconductrice (1) selon l'une quelconque des revendications précédentes, dans laquelle la jonction thermoélectrique bipolaire (2) et la résistance de charge (4) sont agencées pour être placées à une température cryogénique prédéterminée pour assurer l'état supraconducteur de la jonction thermoélectrique bipolaire (2), et le générateur de courant (6) est agencé pour être placé à température ambiante.

4. Procédé d'écriture d'une mémoire thermoélectrique bipolaire supraconductrice comprenant les étapes suivantes :
- la fourniture (200) d'une mémoire thermoélectrique bipolaire supraconductrice (1) selon l'une quelconque des revendications précédentes et l'application d'un gradient thermique à la mémoire thermoélectrique bipolaire supraconductrice (1) ;
- l'injection (202) d'un courant (l_{b}) dans la jonction thermoélectrique bipolaire (2) et la charge résistive (4), provoquant ainsi la génération de la tension de sortie (V_{L}) sur la charge résistive (4) ayant une valeur positive (V_{L}⁺) ou négative (V_{L}⁻) en fonction du signe du courant injecté (l_{b}) ; et
- l'augmentation ou la réduction du courant injecté (l_{b}) de sorte que la tension de sortie (V_{L}) change (204) de signe, changeant ainsi l'état de la mémoire thermoélectrique bipolaire supraconductrice (1).
